# EUROPÄISCHE PATENTANMELDUNG

(11) **EP 1 930 952 A1**
(43) Veröffentlichungstag der Anmeldung: **11.06.2008**
(21) Anmeldenummer: 06025152.7
(22) Anmeldetag: 05.12.2006
(51) Int. Cl.: H01L 29/772

(54) **Vertikale Halbleiterstruktur und Herstellungsverfahren**

(71) Anmelder: SIEMENS AKTIENGESELLSCHAFT, 80333 München (DE)
(72) Erfinder: Elpelt, Rudolf, Dr., 91054 Erlangen (DE); Friedrichs, Peter, Dr., 90475 Nürnberg (DE); Schörner, Reinhold, Dr., 91091 Grossenseebach (DE)

(57) **Zusammenfassung**

Die Halbleiterstruktur (1) dient der Steuerung eines vertikalen Stromflusses zwischen einer ersten und einer zweiten Hauptelektrode (22,23), die jeweils an einer von zwei einander gegenüberliegenden Hauptoberflächen eines Halbleiteraufbaus (5) aus Siliziumcarbid angeordnet sind, mittels eines an einer Steuerelektrode anlegbaren Steuerspannung. Der Halbleiteraufbau (5) umfasst ein Substrat (11), eine auf dem Substrat (11) angeordnete erste Epitaxieschicht (12) mit in abwechselnder Reihenfolge und seitlich nebeneinander angeordneten eingebetteten Gate-Gebieten (19) und vertikalen Kanalgebieten (20) und eine auf der ersten Epitaxieschicht (12) angeordnete zweite Epitaxieschicht (13).

## Beschreibung

Die Erfindung betrifft eine Halbleiterstruktur zur Steuerung eines vertikalen Stromflusses zwischen einer ersten und einer zweiten Hauptelektrode, die jeweils an einer von zwei einander gegenüberliegenden Hauptoberflächen eines Halbleiteraufbaus aus Siliziumcarbid angeordnet sind, mittels einer an einer Steuerelektrode anlegbaren Steuerspannung. Außerdem betrifft die Erfindung ein Verfahren zur Herstellung einer solchen Halbleiterstruktur.

Eine derartige Halbleiterstruktur ist als Static Induction Transistor (SIT) in verschiedenen Ausführungsformen bekannt, wobei insbesondere bei Anwendungen in der Hochfrequenztechnik und vor allem auch bei solchen mit geforderter hoher Sperrspannung das Halbleitermaterial Siliziumcarbid (SiC) verwendet wird. Dieses Material eignet sich aufgrund seiner spezifischen Eigenschaften für solche Anwendungen besonders gut.

Bei einer vertikalen SIT-Struktur wird im eingeschalteten Zustand ein nahezu einheitlich vertikaler Stromfluss durch den Halbleiteraufbau erreicht, wodurch ein besonders günstiger niedriger Durchlasswiderstand resultiert. Unter vertikal ist hierbei eine Orientierung senkrecht zu den Hauptoberflächen zu verstehen. Die Dimensionierung solcher SIT-Strukturen wird mit zunehmender geforderter Sperrspannung immer schwieriger. Die Abstände zwischen den Teilbereichen, die einerseits für die Kontaktierung mit der Steuerelektrode und andererseits für die Kontaktierung mit der einen Hauptelektrode vorgesehen sind, werden dann bei den bekannten SiC-SIT-Strukturen sehr klein. Auch deshalb sind solche Bauelemente bislang noch nicht bis zur Marktreife entwickelt worden.

Aus den US 5,612,547 und US 5,945,701 sind SiC-SIT-Strukturen mit Gräben bekannt, wobei an den Böden der Gräben Schottky-Steuerkontakte bzw. p-Gate-Steuerkontakte vorgesehen sind.

Dieser Aufbau lässt sich für Sperrspannungen von um die 1000 V technologisch nur äußerst schwer umsetzen.

Eine andere ebenfalls Gräben aufweisende SiC-SIT-Struktur wird in der US 6,917,054 B2 beschrieben. Die p-Gate-Gebiete sind außer an den Böden der Gräben auch an den Seitenwänden vorgesehen. Sie erstrecken sich teils bis unmittelbar an die n-Source-Kontaktgebiete, die an der Oberseite von zwischen den Gräben stehenden Stegen vorgesehen sind. Dieser Aufbau ist technologisch aufwändig, da zur Dotierung der Seitenwände schräge Implantationen erforderlich sind. Außerdem erlaubt der unmittelbare Kontakt zwischen den jeweils hochdotierten p-Gate-Gebieten und n-Source-Kontaktgebieten nur eine verhältnismäßig geringe Abschnürspannung zwischen Gate und Source.

In dem unter der Internet-Adresse "http://www.aist.go.jp/aist_e/latest_research/2005/20050407/20050407.html" publizierten Fachaufsatz "Top Performance of SiC Power Transistor Designed for Inverters" wird eine Gräben aufweisende SiC-SIT-Struktur beschrieben, die mittels dreier Epitaxieschritte hergestellt wird. Dies ist aufwändig.

Aus der US 6,750,477 B2 ist eine planare SiC-SIT-Struktur bekannt, bei der mehrere gleichartige planare Halbleiteraufbauten in einer übergeordneten Zellstruktur seitlich nebeneinander angeordnet und elektrisch parallel geschaltet sind. Aufgrund des planaren Aufbaus sind nur relativ geringe Sperrspannungen zu erzielen.

Eine Aufgabe der Erfindung besteht deshalb darin, eine Halbleiterstruktur der eingangs bezeichneten Art anzugeben, die auch in hochsperrender Ausführungsform einfach hergestellt werden kann.

Diese Aufgabe wird gelöst durch die Merkmale des unabhängigen Patentanspruchs 1. Bei der erfindungsgemäßen Halbleiterstruktur handelt es sich um eine solche, bei der der Halbleiteraufbau ein Substrat, eine auf dem Substrat angeordnete erste Epitaxieschicht mit in abwechselnder Reihenfolge und seitlich nebeneinander angeordneten eingebetteten Gate-Gebieten und vertikalen Kanalgebieten und eine auf der ersten Epitaxieschicht angeordnete zweite Epitaxieschicht umfasst, die Gate-Gebiete einen zum übrigen Halbleiteraufbau entgegen gesetzten Leitungstyp aufweisen und in einem Randbereich des Halbleiteraufbaus durch die Steuerelektrode gemeinsam kontaktiert sind und an einer Grenzfläche zwischen den beiden Epitaxieschichten in der ersten Epitaxieschicht grabenförmige Ausnehmungen mit jeweils schrägen Seitenwänden und einem Boden vorgesehen sind, wobei sich jedes Gate-Gebiet angrenzend an die Seitenwände und den Boden eines der Ausnehmungen in die erste Epitaxieschicht erstreckt.

Die erfindungsgemäße Halbleiterstruktur lässt sich besonders einfach herstellen. Sie kommt insbesondere mit zwei Epitaxieschichten aus. Technologische Schwierigkeiten, wie eine elektrisch voneinander getrennte Kontaktierung von auf engstem Raum nebeneinander liegenden Grabenböden (Gate-Kontaktierung) und Stegoberflächen (Source-Kontaktierung), treten strukturbedingt nicht auf. Die die Gate-Gebiete bestimmenden Ausnehmungen in der ersten Epitaxieschicht sind insbesondere vollständig und durchgehend mit der zweiten Epitaxieschicht überwachsen, so dass auf deren Oberfläche eine insbesondere durchgehende Metallisierung für die eine Hauptelektrode (Source-Elektrode) aufgebracht werden kann. Die Kontaktierung der Gate-Gebiete erfolgt dagegen am Rand des Halbleiteraufbaus.

Eine für eine Ätzung der Ausnehmungen ohnehin erforderliche Maske kann im Anschluss an den Ätzschritt auch für die Ionenimplantation der Gate-Gebiete verwendet werden. Diese Doppelfunktion vereinfacht die Herstellung. Außerdem führt sie zu einer automatisch korrekten Justage der Gate-Gebiete. Letztere werden somit selbstjustiert gefertigt.

Weiterhin ist aufgrund der geneigten Seitenwände keine mehrstufige Implantation mit zum Teil schrägen Implantationswinkeln erforderlich. Ein einziger Implantationsschritt mit senkrechtem Beschusswinkel reicht aus.

Außerdem kann eine sehr enge Packungsdichte realisiert werden. Es können also sehr geringe Abmessungen für die grabenförmigen Ausnehmungen und ihre Abstände zueinander vorgesehen werden. Dadurch ist ein sehr niedriger Durchlasswiderstand möglich. Gleichzeitig kann eine hohe Sperrspannungsfestigkeit erzielt werden. Die u.a. für die erzielbare Sperrspannung maßgebliche Länge des vertikalen Kanalgebiets lässt sich problemlos und in weiten Grenzen über die Tiefe der Ausnehmungen einstellen.

Vorteilhafte Ausgestaltungen der erfindungsgemäßen Halbleiterstruktur ergeben sich aus den Merkmalen der von Anspruch 1 abhängigen Ansprüche.

Günstig ist eine Variante, bei der sich die Kanalgebiete und die Gate-Gebiete in einer Längsrichtung erstrecken. Die insbesondere parallel zueinander verlaufenden Kanalgebiete und Gate-Gebiete sind dann also vorzugsweise senkrecht zur vertikalen und zur seitlichen Richtung orientiert. Mit Vorteil ist diese Längsrichtung außerdem senkrecht zu Wachstumsstufen orientiert, die sich in den Epitaxieschichten aufgrund einer Fehlorientierung des Substrats bezüglich einer Kristallhauptachse ergeben. Dann wächst die zweite Epitaxieschicht besonders günstig und vor allem einheitlich auf die mit Gräben versehene Oberfläche der ersten Epitaxieschicht auf. Ein vollständiges Überwachsen ist so gewährleistet.

Weiterhin können die Gate-Gebiete vorzugsweise im Inneren des Halbleiteraufbaus vollständig in Halbleitermaterial eingebettet sein, dessen Dotierung niedriger ist als die der Kanalgebiete und insbesondere auch als die eines an einer von den Gate- und Kanalgebieten abgewandten Seite der zweiten Epitaxieschicht vorgesehenen Kontaktgebiets. Die Dotierstoffkonzentrationen sind hier unabhängig vom Leitungstyp des jeweiligen Gebiets zu verstehen. Keine vollständige Einbettung ist dagegen am Rand des Halbleiteraufbaus, insbesondere an den Längsenden der Gate-Gebiete, gegeben, da hier zugängliche Anschlussbereiche zur Kontaktierung mit der Steuerelektrode vorgesehen sind. Die vollständige Einbettung im Inneren des Halbleiteraufbaus verhindert einen direkten Kontakt zwischen den üblicherweise hochdotierten Gate-Gebieten und Source-Kontaktgebieten. So ist die Spannungsfestigkeit zwischen Source und Gate auch dann noch gewährleistet, wenn höhere, z.B. im Bereich von einigen 10 V und insbesondere von bis zu 50 V liegende, Abschnürspannungen gewünscht werden.

Gemäß einer anderen günstigen Variante haben die grabenförmigen Ausnehmungen eine Tiefe von mindestens 2 *µ*m, vorzugsweise von zwischen 2 *µ*m und 4 *µ*m. Damit kann eine hohe Sperrspannungsfestigkeit von bis zu über 1000 V und insbesondere von bis zu 1200 V erreicht werden. Grundsätzlich kann die erfindungsgemäße Halbleiterstruktur aber auch für niedrigere oder noch höhere Sperrspannungen realisiert werden. Anhand der Grabentiefe lassen sich die Länge der vertikalen Kanalgebiete und damit das Sperrvermögen in weiten Grenzen einstellen.

Vorzugsweise ist es außerdem vorgesehen, dass die Kanalgebiete eine mittlere seitliche Ausdehnung von zwischen 2 µm und 5 µm haben. Die Mittelwertbildung berücksichtigt dabei die aufgrund der Seitenwandneigung der Ausnehmungen in vertikaler Richtung nicht einheitliche seitliche Abmessung der Kanalgebiete. Mit den genannten besonders günstigen Werten für den Seitenabstand zwischen benachbarten Gate-Gebieten wird ein sehr hohe Packungsdichte und damit ein besonders niedriger Durchlasswiderstand erzielt.

Bei einer weiteren vorteilhaften Ausgestaltung haben die Seitenwände der grabenförmigen Ausnehmungen einen gegenüber einer vertikalen Richtung gemessenen Neigungswinkel von zwischen 10° und 30°, insbesondere von zwischen 12° und 20°. Dann lassen sich die Gate-Teilgebiete in den Seitenwänden der Ausnehmungen besonders einfach und vorzugsweise mit einem einzigen und unter einem geraden Beschusswinkel durchgeführten Implantationsschritt herstellen.

Eine weitere Aufgabe der Erfindung besteht darin, ein Verfahren zur Herstellung einer Halbleiterstruktur der eingangs bezeichneten Art anzugeben, das auch für eine hochsperrende Halbleiterstruktur einfach durchgeführt werden kann.

Diese Aufgabe wird gelöst durch die Merkmale des unabhängigen Patentanspruchs 7. Bei dem erfindungsgemäßen Herstellungsverfahren handelt es sich um eine solche, bei dem der Halbleiteraufbau hergestellt wird, indem eine erste Epitaxieschicht auf ein Substrat aufgebracht wird, die erste Epitaxieschicht mit einer Bearbeitungsöffnungen aufweisenden Maskierschicht belegt wird, mehrere seitlich voneinander beabstandete grabenförmige Ausnehmungen mit jeweils schrägen Seitenwänden und einem Boden an von der Maskierschicht nicht abgedeckten Bereichen in die erste Epitaxieschicht geätzt werden, ein Implantationsschritt zur gleichzeitigen Dotierung der schrägen Seitenwände und des Bodens jeder der Ausnehmungen durchgeführt wird, so dass dort Gate-Gebiete mit einem zum übrigen Halbleiteraufbau entgegen gesetzten Leitungstyp gebildet werden, die Maskierschicht entfernt wird, eine zweite Epitaxieschicht auf die mit den Ausnehmungen versehene erste Epitaxieschicht aufgebracht wird und ein Kontaktgebiet an einer von der ersten Epitaxieschicht abgewandeten Seite der zweiten Epitaxieschicht erzeugt wird.

Vorteilhafte Ausgestaltungen des erfindungsgemäßen Herstellungsverfahrens ergeben sich aus den von Anspruch 7 abhängigen Ansprüchen. Das erfindungsgemäße Herstellungsverfahren und seine Ausgestaltungen bieten im Wesentlichen die gleichen Vorteile, die bereits im Zusammenhang mit der erfindungsgemäßen Halbleiterstruktur und deren Varianten beschrieben worden sind.

Darüber hinaus ist eine Variante bevorzugt, bei der die beiden Epitaxieschichten mit im Wesentlichen gleicher Grunddotierung aufgebracht werden. Diese beiden Schichten tragen sowohl im stromführenden als auch im sperrenden Zustand wesentlich zur Funktion der Halbleiterstruktur bei. Eine gleiche Grunddotierung führt an der Grenzfläche zwischen den beiden Epitaxieschichten und dort vor allem im Bereich der vertikalen Kanalgebiete zu einem möglichst homogenen Verhalten. Insbesondere stellt die zweite Epitaxieschicht die Trennschicht zwischen den üblicherweise hochdotierten Gate-Gebieten und Source-Kontaktgebieten dar. Sie sollte deshalb nicht zu hoch dotiert sein, um die Sperrfähigkeit der Gate-Source-Diode zu gewährleisten. Andererseits führt eine zu geringe Dotierung zu einer Erhöhung des Durchlasswiderstands.

Weiterhin ist es vorzugsweise vorgesehen, dass auf dem Substrat eine Zellenstruktur aus mehreren gleich ausgebildeten und nebeneinander angeordneten Zellen jeweils in Form des Halbleiteraufbaus hergestellt wird, wobei die einzelnen Zellen zur Bildung der Halbleiterstruktur elektrisch parallel geschaltet werden. Die Zellstruktur lässt sich leicht fertigen. Sie erhöht die insgesamt erzielbare Stromtragfähigkeit und erleichtert eine Kontaktierung der Gate-Gebiete.

Weitere Merkmale, Vorteile und Einzelheiten der Erfindung ergeben sich aus der nachfolgenden Beschreibung von Ausführungsbeispielen anhand der Zeichnung. Es zeigt:
- FIG 1: ein Ausführungsbeispiel einer Halbleiterstruktur in Zellendesign in Draufsicht und mit vergrößerter Darstellung einer Zelle,
- FIG 2 bis 4: Querschnitte durch die Halbleiterstruktur gemäß FIG 1,
- FIG 5: eine perspektivische Ansicht eines inneren Bereichs einer Zelle der Halbleiterstruktur gemäß FIG 1,
- FIG 6 und 7: einen zur Herstellung der Halbleiterstruktur gemäß FIG 1 verwendeten Siliziumcarbid-Wafer mit Fehlorientierung bezüglich einer Kristallhauptachse,
- FIG 8 bis 13: Abfolge der Herstellungsschritte bei der Fertigung der Halbleiterstruktur gemäß FIG 1,
- FIG 14: Vertikaler Stromfluss durch die Halbleiterstruktur gemäß FIG 1 und
- FIG 15 bis 18: Diagramme mit Kennlinien der Halbleiterstruktur gemäß FIG 1.

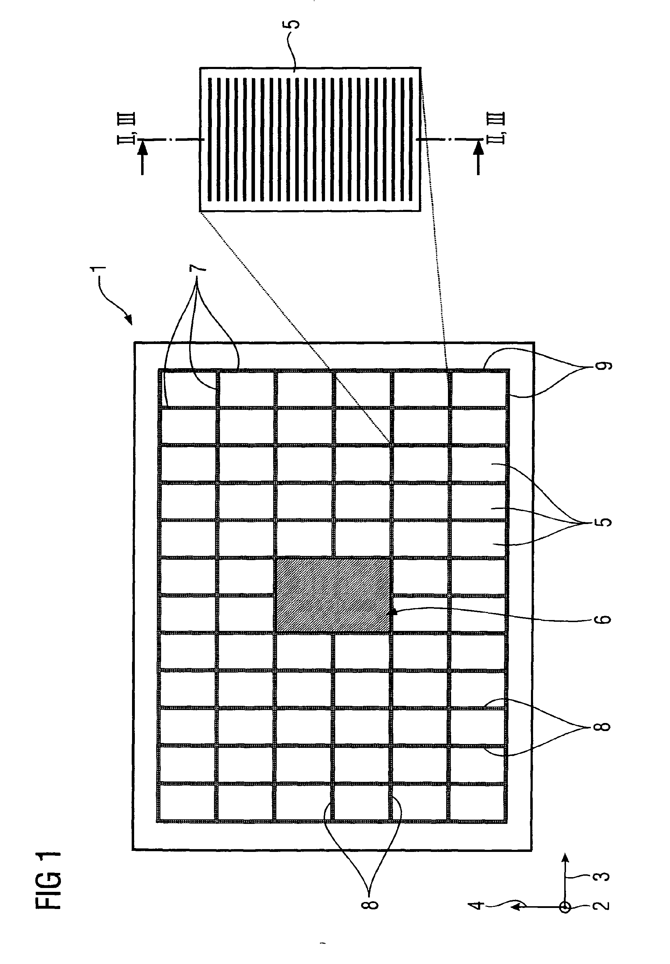

Einander entsprechende Teile sind in FIG 1 bis 18 mit denselben Bezugszeichen versehen.

In FIG 1 ist ein Ausführungsbeispiel einer Halbleiterstruktur in Form einer SIT(Static Induction Transistor)-Struktur 1 in Draufsicht gezeigt. Die SIT-Struktur 1 hat ist flächig ausgebildet. Sie ist ein vertikales Bauelement, das zur Steuerung eines vertikalen, also eines senkrecht zu den Hauptoberflächen orientierten, Stromflusses dient. Eine vertikale Richtung ist mit 2 bezeichnet.

Die SIT-Struktur 1 ist aus mehreren in einer Längsrichtung 3 und in einer seitlichen Richtung 4 nebeneinander angeordneten Zellen 5 aufgebaut. Die Richtungen 2 bis 4 sind jeweils senkrecht zueinander. Im Zentrum der SIT-Struktur 1 ist eine Gate-Anschlusszone 6 zum Anschließen (Bonden) einer als Gate-Elektrode 7 ausgebildeten Steuerelektrode vorgesehen. Die Gate-Elektrode 7 verläuft ansonsten netzartig zwischen den Zellen 5. Letztere sind jeweils durch einen die Gate-Elektrode 7 aufnehmenden Gate-Kontaktierungsbereich 8 voneinander getrennt. Die Gate-Elektrode 7 ist also im Randbereich jeder Zelle 5 angeordnet.

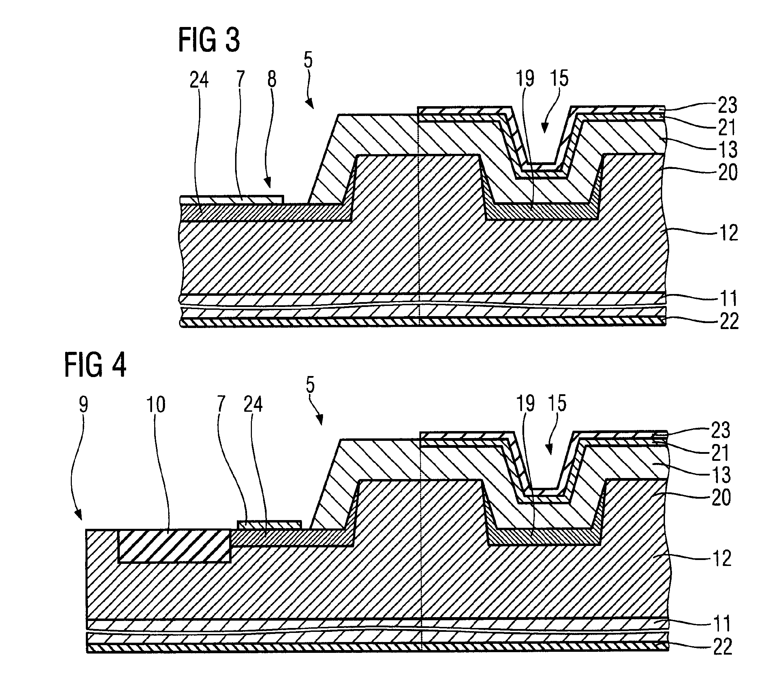

Am äußeren Rand 9 der SIT-Struktur 1 ist neben der auch hier die außen angeordneten Zellen 5 umgebenden Gate-Elektrode 7 zusätzlich ein in FIG 4 näher gezeigter Randabschluss 10 vorgesehen.

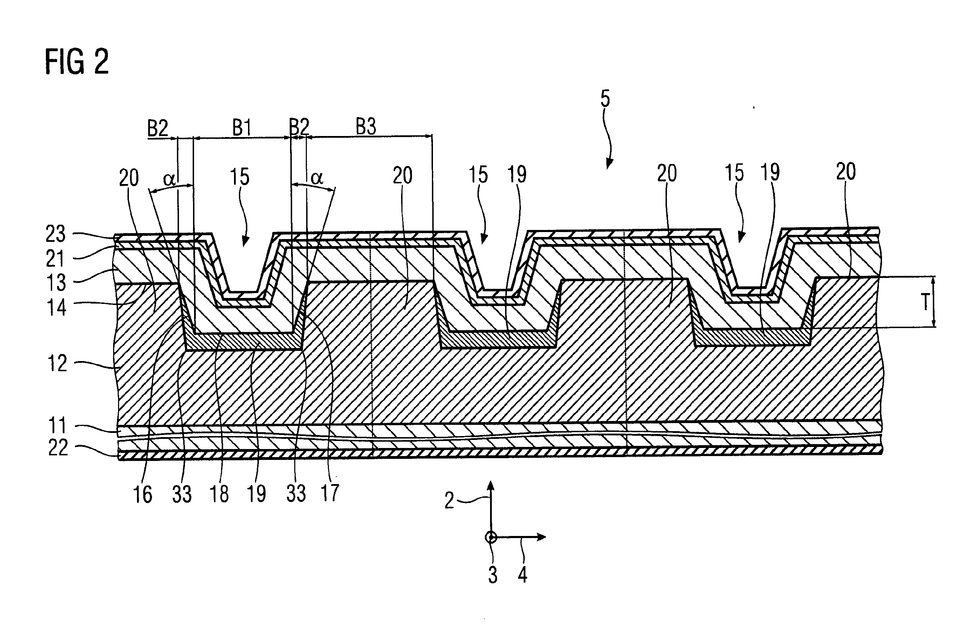

Jede der als eigener Halbleiteraufbau ausgebildeten Zellen 5 hat ihrerseits eine mehrzellige Unterstruktur. Wie aus der in FIG 1 gezeigten vergrößerten schematischen Darstellung einer der Zellen 5 hervorgeht, sind mehrere längliche Gebiete vorgesehen, die sich in die Längsrichtung 3 erstrecken und in der seitlichen Richtung 4 abwechseln. Details des Aufbaus der Zellen 5 sind in den Querschnittsdarstellungen gemäß FIG 2 und 3 gezeigt.

Gemäß FIG 2 umfasst der flächige Halbleiteraufbau der Zellen 5 ein hoch dotiertes Substrat 11 eines ersten Leitungstyps, der im Ausführungsbeispiel der n-Leitungstyp ist. Auf dem Substrat 11 ist eine demgegenüber niedriger dotierte erste Epitaxieschicht 12 mit dem gleichen ersten Leitungstypen angeordnet. Auf der erste Epitaxieschicht 12 zweite Epitaxieschicht 13 angeordnet, die insbesondere die gleiche Dotierung hat wie die erste Epitaxieschicht 12.

Eine Grenzfläche 14 zwischen den beiden Epitaxieschichten 12 und 13 ist uneben. Sie weist mit periodischem seitlichen Abstand zueinander angeordnete grabenförmige Ausnehmungen 15 auf, die in der ersten Epitaxieschicht 12 angeordnet sind und in die Längsrichtung 3 verlaufen. Die Ausnehmungen 15 haben schräge Seitenwände 16 und 17 und einen Boden 18, so dass sich ein im Wesentlichen trapezförmiger Querschnitt ergibt. Die Seitenwände 16 und 17 öffnen sich in Richtung der zweiten Epitaxieschicht 13 mit einem gegenüber der vertikalen Richtung 2 gemessenen Neigungswinkel α. Die Ausnehmungen 15 haben eine in der vertikalen Richtung 2 gemessene Grabentiefe T und an den Böden 18 eine in der seitlichen Richtung 4 gemessene Grabenbreite B1. Ihre Seitenwände 16 und 17 erstrecken sich in der seitlichen Richtung 4 jeweils über eine Flankenbreite B2.

Angrenzend an die Seitenwände 16 und 17 sowie an den Boden 18 jeder der Ausnehmungen 15 erstreckt sich jeweils ein hoch dotiertes Gate-Gebiet 19 eines dem ersten entgegengesetzten zweiten Leitungstyps in die erste Epitaxieschicht 12. Die Gate-Gebiete 19 sind im Ausführungsbeispiel also p-leitend. Sie haben einen in etwa U-förmigen Querschnitt, wobei sich die U-Schenkel mit dem Neigungswinkel α nach oben öffnen. Auch die Gate-Gebiete 19 haben also jeweils durch die U-Schenkel gebildete schräge Seitenwände.

Abgesehen von den Längsenden, mit denen die Gate-Gebiete 19 in die im Randbereich um jede Zelle 5 umlaufenden Gate-Kontaktierungsbereiche 8 münden, sind die Gate-Gebiete 19 vollständig eingebettet. Im Inneren der Zellen 5 sind sie von dem Halbleitermaterial der beiden Epitaxieschichten 12 und 13 umgeben. Die zweite Epitaxieschicht 13 erstreckt sich insbesondere durchgehend bis zu den Böden 18 der Ausnehmungen 15.

Zwischen den Gate-Gebieten 19 sind jeweils vertikale Kanalgebiete 20 angeordnet, die im Wesentlichen durch die zwischen den Ausnehmungen 15 verlaufenden Längsstege gebildet sind. Die Gate-Gebiete 19 und die Kanalgebiete 20 sind also in der seitlichen Richtung 4 nebeneinander und in abwechselnder Reihenfolge angeordnet. Die die Struktur bestimmenden Ausnehmungen 15 und die dazwischen liegenden Längsstege erstrecken sich parallel zueinander in die Längsrichtung 3. Die Längsstege haben an der Grenzfläche 14 eine in der seitlichen Richtung 4 gemessene Stegbreite B3.

An einer von der Grenzfläche 14 abgewandten Oberfläche der zweiten Epitaxieschicht 13 ist ein hoch dotiertes Source-Kontaktgebiet 21 des ersten Leitungstyps in der zweiten Epitaxieschicht 13 vorgesehen.

Sowohl die hoch p-dotierten Gate-Gebiete 19 als auch das hoch n-dotierte Source-Kontaktgebiet 21 sind mittels Ionenimplantationen in den beiden Epitaxieschichten 12 und 13 gebildet. Die verbleibenden niedrig n-dotierten Bereiche der beiden Epitaxieschichten 12 und 13 bilden ein zur vertikalen Stromführung durch die jeweilige Zelle 5 der SIT-Struktur 1 bestimmtes Driftgebiet, das also insbesondere auch die vertikalen Kanalgebiete 20 umfasst.

An einer von der ersten Epitaxieschicht 12 abgewandten Unterseite des Substrats 11 ist eine Rückseitenmetallisierung zur Bildung einer Hauptelektrode, nämlich einer Drain-Elektrode 22, vorgesehen. Auf eine an das Source-Kontaktgebiet 21 angrenzende Oberfläche der zweiten Epitaxieschicht 13 ist ebenfalls eine Metallisierung aufgebracht. Sie bildet eine zweite Hauptelektrode, nämlich eine Source-Elektrode 23. Die beiden Hauptelektroden 22 und 23 sind also jeweils an einer der beiden in der vertikalen Richtung 2 einander gegenüberliegenden Hauptoberflächen der Zelle 5 angeordnet.

Gemäß FIG 3 ist ersichtlich, dass die Gate-Elektrode 7 im Gate-Kontaktierungsbereich 8, also im Randbereich jeder Zelle 5, als Metallisierung auf ein freigelegtes hoch p-dotiertes Gate-Gebiet 24 aufgebracht ist. Das freigelegte Gate-Gebiet 24 ist an den Längsstirnseiten jeder Zelle 5 mit den ansonsten eingebetteten Gate-Gebieten 19 verbunden, so dass die Gate-Elektrode 7 alle Gate-Gebiete 19 gemeinsam elektrisch kontaktiert.

Der der Darstellung gemäß FIG 4 zu entnehmende und am äußeren Rand der SIT-Struktur 1 als äußere Begrenzung vorgesehene Randabschluss 10 hat den zweiten Leitungstyp. Er ist im Ausführungsbeispiel also wie die Gate-Gebiete 19 und 24 p-leitend. Er erstreckt sich aber tiefer als diese in die erste Epitaxieschicht 12. Außerdem ist seine Dotierung niedriger als die der Gate-Gebiete 19 und 24. Grundsätzlich sind aber auch andere Randabschlüsse, wie z.B. Feldringe, möglich.

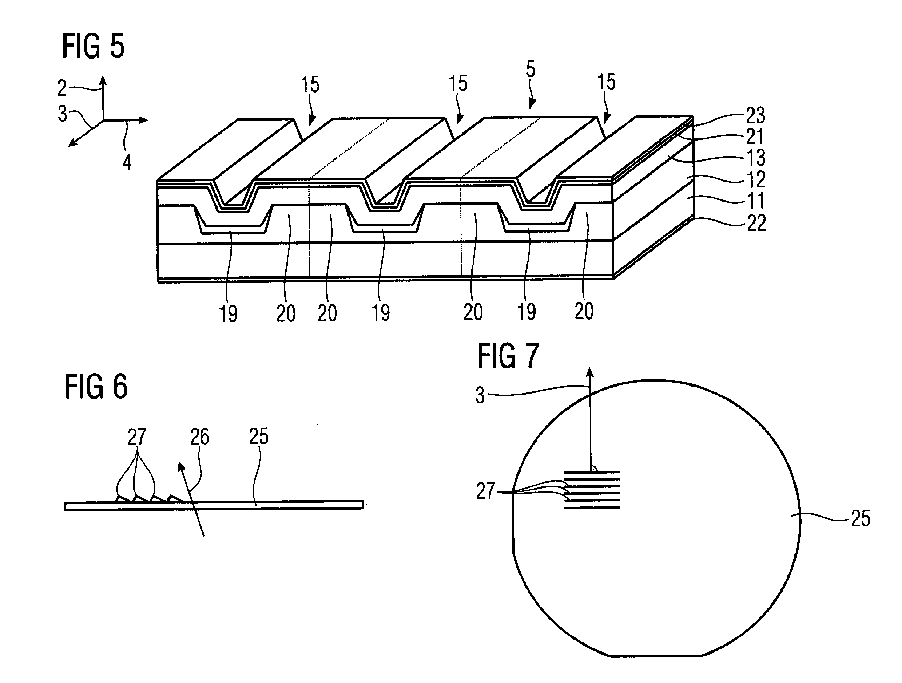

Der mehrzellige Aufbau im Innenbereich jeder der Zellen 5 geht auch aus der perspektivischen Ansicht gemäß FIG 5 hervor. Diese Darstellung umfasst ähnlich wie die gemäß FIG 2 drei der länglichen streifenförmigen Unterzellen, aus denen sich die Zellen 5 jeweils zusammensetzen.

Die SIT-Struktur 1 ist mit dem Halbleitermaterial Siliziumcarbid (SiC) realisiert. Das einkristalline SiC-Material kann in verschiedenen Polytyp-Ausprägung vorliegen, beispielsweise als 3C-, 4H- oder 6H-SiC. Einkristallines SiC eignet sich aufgrund seiner herausragenden Materialeigenschaften besonders gut für Anwendungen bei hohen Leistungen und Temperaturen. Mit diesem Halbleitermaterial realisierte Schaltelemente, wie beispielsweise auch die SIT-Struktur 1, können im gesperrten Zustand sehr hohe Spannungen aufnehmen und im Durchlasszustand sehr hohe Ströme führen. So hat die SIT-Struktur 1 ein Sperrvermögen von bis zu 1200 V. Grundsätzlich sind hier auch aber andere niedrigere oder höhere Werte realisierbar.

Das für die SIT-Struktur 1 verwendete Substrat 11 ist Bestandteil eines in FIG 6 und 7 gezeigten Sic-Wafers 25, dessen Oberflächennormale eine gewisse Fehlorientierung zu einer Kristallhauptachse 26 aufweist. Diese Fehlorientierung liegt insbesondere bei einigen wenigen Grad, beispielsweise zwischen 0,5° und 8°. Sie erleichtert das epitaktische Wachstum auf dem Substrat 11. Beim Aufwachsen der Epitaxieschichten 12 und 13 bilden sich aufgrund der Fehlorientierung Wachstumsstufen 27, die schematisch in FIG 6 und 7 angedeutet sind. Die SIT-Struktur 1 ist definiert bezüglich dieser Wachstumsstufen 27 ausgerichtet. Die Längsrichtung 3 ist senkrecht zu diesen im Wesentlichen zueinander parallel verlaufenden Wachstumsstufen 27 orientiert. Dann wächst die zweite Epitaxieschicht 13 besonders homogen und vor allem ohne Unterbrechungen oder Hinterschneidungen auf die mit den grabenförmigen Ausnehmungen 15 versehene Grenzfläche 14 auf.

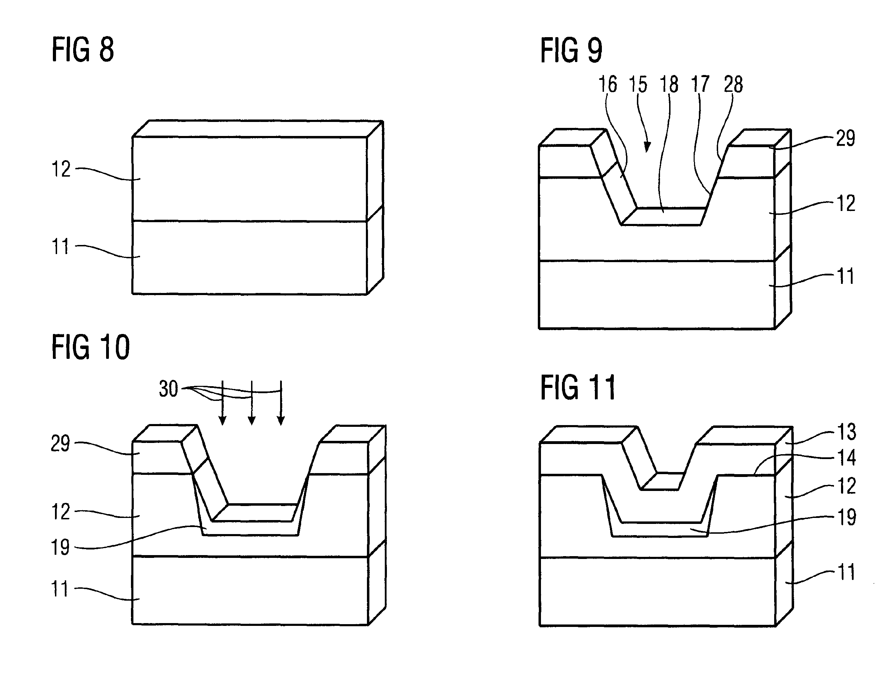

In FIG 8 bis 14 ist die wesentliche Fertigungsabfolge der SIT-Struktur 1 beispielhaft anhand einer innen liegenden Unterzelle der Zellen 5 gezeigt, wobei die übrigen Unterzellen und auch alle weiteren Zellen 5 parallel in gleicher oder ähnlicher Weise hergestellt werden.

Die erste Epitaxieschicht 12 wird mittels epitaktischen Wachstums auf das Substrat 11 aufgebracht (FIG 8). Die aufgewachsene erste Epitaxieschicht 12 wird maskiert, indem eine mit Bearbeitungsöffnungen 28 versehene Maske 29 (= Maskierschicht) aufgebracht wird. An den von der Maske 29 nicht abgedeckten Bereichen werden die grabenförmigen Ausnehmungen 15 aus der ersten Epitaxieschicht 12 herausgeätzt. Diese Ätzschritt erfolgt also durch die Bearbeitungsöffnungen 28 hindurch (FIG 9) .

Anschließend werden sowohl die schrägen Seitenwände 16 und 17 als auch der Boden 18 der Ausnehmungen 15 gleichzeitig mit Ionen 30 beschossen, um mittels eines einzigen Ionenimplantationsschrittes die hoch p-leitenden Gate-Gebiete 19 und 24 herzustellen. Auch dieser Implantationsschritt erfolgt durch die Bearbeitungsöffnungen 28 der Maske 29 hindurch (FIG 10).

Danach wird die doppelt verwendete Maske 29 entfernt. Auf die mit den Ausnehmungen 15 versehene Grenzfläche 14 der ersten Epitaxieschicht 12 wird dann die zweite Epitaxieschicht 13 aufgebracht. Auch diese erfolgt mittels epitaktischen Wachstums, wobei die zweite Epitaxieschicht 13 aufgrund der vorgesehenen senkrechten Orientierung der Längsrichtung 3 bezüglich der Wachstumsstufen 27 sehr einheitlich und als durchgehende Schicht auch im Bereich der Ausnehmungen 15 aufwächst (FIG 11) .

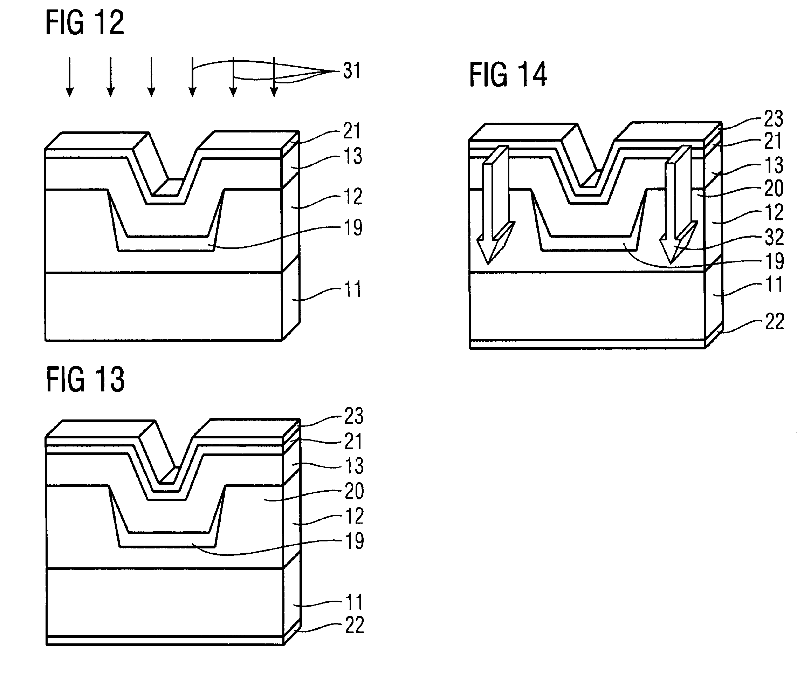

In einem weiteren Ionenimplantationsschritt wird an einer von der ersten Epitaxieschicht 12 abgewandeten Seite der zweiten Epitaxieschicht 13 das hoch n-leitende Source-Kontaktgebiet 21 erzeugt wird, indem die Oberfläche der zweiten Epitaxieschicht 13 mit Ionen 31 beschossen wird (FIG 12).

Es schließen sich Metallisierungsschritte an der Unter- und Oberseite des Halbleiteraufbaus zur Bildung der Drain- bzw. Source-Elektrode 22 bzw. 23 sowie zur Bildung der Gate-Elektrode 7 an (FIG 13).

Die skizzierte Fertigungsabfolge lässt sich einfach durchführen. Es fallen nur wenige hochpräzise vorzunehmende Prozessschritte, wie beispielsweise das Aufbringen der Maske 29, an.

Dennoch erfolgt die Fertigung der SIT-Struktur 1 insgesamt und vor allem die der für die Funktion maßgeblichen benachbarten Gate-Gebiete 19 und Kanalgebiete 20 sehr exakt. Insbesondere die Gate-Gebiete 19 lassen sich auf diese Weise selbst justiert herstellen. Aufwändige gesonderte Justage-Maßnahmen sind nicht erforderlich. Trotzdem ist eine sehr enge Packungsdichte der Unterzellen möglich, so dass im eingeschalteten Zustand ein niedriger Einschaltwiderstand resultiert, ohne die hohe Sperrspannungsfähigkeit im gesperrten Zustand zu beeinträchtigen. Der niedrige Einschalt- oder Durchlasswiderstand kommt auch von der sehr weitgehenden Ausnutzung des Halbleitervolumens für einen in FIG 14 gezeigten vertikalen Stromfluss 32 durch die SIT-Struktur 1.

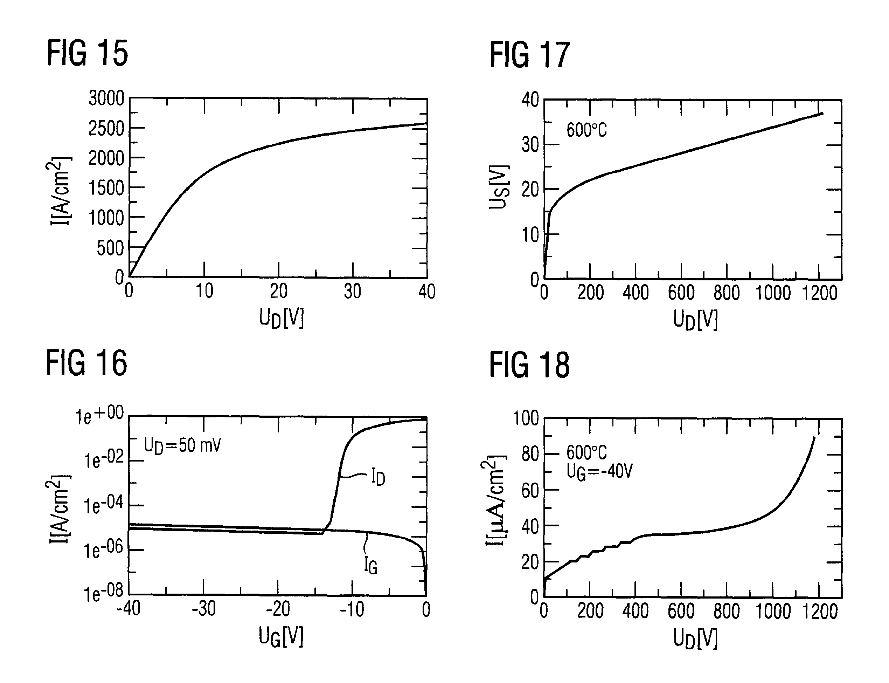

Für ein Ausführungsbeispiel der SIT-Struktur 1 sind in FIG 15 bis 18 Diagramme mit den das Sperr- und Durchlassverhalten beschreibenden Kennlinien angegeben.

Bei dem Ausführungsbeispiel ist zwischen dem Substrat 11 und der ersten Epitaxieschicht 12 zusätzlich eine Bufferschicht vorgesehen. Diese ist optional. Sie hat eine vertikale Abmessung von 2 µm und eine n-Dotierung von 2*10¹⁷ cm⁻³. Die beiden Epitaxieschicht 12 und 13 haben hier ein gleiche niedrige n-Dotierung von 6*10¹⁵ cm⁻³. Die erste Epitaxieschicht 12 hat eine vertikale Ausdehnung von 12 µm, die zweite Epitaxieschicht 13 von 1 µm. Die hohe p-Dotierung der Gate-Gebiete 19 liegt im Bereich zwischen 10¹⁸ cm⁻³ und 10¹⁹ cm⁻³. Die Grabentiefe T der Ausnehmungen 15 ist 3 µm, die Grabenbreite B1 2 µm und die Flankenbreite B2 1,5 µm. Der Neigungswinkel α der Seitenwände 16 und 17 beträgt etwa 30°. Die Längsstege und damit die Kanalgebiete 20 haben eine obere Stegbreite B3 von 3 µm.

Für dieses Ausführungsbeispiel der SIT-Struktur 1 ergeben sich die folgenden Kennlinien. Bei der in FIG 15 gezeigten Durchlasskennlinie ist die Stromdichte I über der Drain-Spannung U_{D} aufgetragen. In FIG 16 sind die Transferkennlinien für den Drain-Strom I_{D} und den Gate-Strom I_{G} angegeben, wobei die jeweilige Stromdichte I über der Gate-Spannung U_{G} (= Steuerspannung) bei einer Drain-Spannung U_{D} von 50 mV aufgetragen ist. In FIG 17 ist die Gate-Drain-Kennlinie für eine Temperatur von 600°C dargestellt, wobei das Source-Potential U_{S} über der Drain-Spannung U_{D} aufgetragen ist. In FIG 18 ist die Sperrkennlinie für eine Gate-Spannung U_{G} von -40V und für eine Temperatur von 600°C dargestellt, wobei die Stromdichte I über der Drain-Spannung U_{D} aufgetragen ist.

Aus der Kennlinie gemäß FIG 18 ist das hohe Sperrvermögen ersichtlich. Sperrspannungen von bis zu über 1000 V können aufgenommen werden. Der bei noch höheren Sperrspannungen auftretende Avalanche-Durchbruch verteilt sich bei der SIT-Struktur 1 auf viele Stellen innerhalb der Zellen 5, so dass es zu keiner lokalen Überlastung und als Folge davon zu einer Zerstörung des Bauelements kommt. Der Avalanche-Durchbruch erfolgt praktisch gleichzeitig an allen unteren Eckkanten 33 der Gate-Gebiete 19.

Wie weiterhin der Durchlasskennlinie gemäß FIG 16 und der Gate-Drain-Kennlinie gemäß FIG 17 zu entnehmen ist, hat die SIT-Struktur bis zu sehr hohen Stromdichten ein weitgehend lineares Strom-Spannungs-Verhalten bzw. ein pentodenähnliches Abschnürverhalten.

Bei einem anderen ähnlich günstigen Ausführungsbeispiel liegen andere Geometrieabmessungen vor. So beträgt bei diesem alternativen Ausführungsbeispiel die Grabenbreite B1 etwa 7 µm, die Flankenbreite B2 etwa zwischen 0,6 und 1,0 µm sowie die obere Stegbreite B3 etwa 3 µm.

## Patentansprüche

1. Halbleiterstruktur zur Steuerung eines vertikalen Stromflusses (32) zwischen einer ersten und einer zweiten Hauptelektrode (22, 23), die jeweils an einer von zwei einander gegenüberliegenden Hauptoberflächen eines Halbleiteraufbaus (5) aus Siliziumcarbid angeordnet sind, mittels eines an einer Steuerelektrode (7) anlegbaren Steuerspannung (U_{G}), wobei
a) der Halbleiteraufbau (5) ein Substrat (11), eine auf dem Substrat (11) angeordnete erste Epitaxieschicht (12) mit in abwechselnder Reihenfolge und seitlich nebeneinander angeordneten eingebetteten Gate-Gebieten (19) und vertikalen Kanalgebieten (20) und eine auf der ersten Epitaxieschicht (12) angeordnete zweite Epitaxieschicht (13) umfasst,
b) die Gate-Gebiete (19) einen zum übrigen Halbleiteraufbau (5) entgegen gesetzten Leitungstyp aufweisen und in einem Randbereich des Halbleiteraufbaus (5) durch die Steuerelektrode (7) gemeinsam kontaktiert sind und
c) an einer Grenzfläche (14) zwischen den beiden Epitaxieschichten (12, 13) in der ersten Epitaxieschicht (12) grabenförmige Ausnehmungen (15) mit jeweils schrägen Seitenwänden (16, 17) und einem Boden (18) vorgesehen sind, wobei sich jedes Gate-Gebiet (19) angrenzend an die Seitenwände (16, 17) und den Boden (18) eines der Ausnehmungen (15) in die erste Epitaxieschicht (12) erstreckt.

2. Halbleiterstruktur nach Anspruch 1, **dadurch gekenn-zeichnet**, dass sich die Kanalgebiete (20) und die Gate-Gebiete (19) in einer Längsrichtung (3) erstrecken, die senkrecht zu Wachstumsstufen (27) orientiert ist, die sich in den Epitaxieschichten (12, 13) aufgrund einer Fehlorientierung des Substrats (11) bezüglich einer Kristallhauptachse (26) ergeben.

3. Halbleiterstruktur nach Anspruch 1, **dadurch gekennzeichnet, dass** die Gate-Gebiete (19) im Inneren des Halbleiteraufbaus (5) vollständig in Halbleitermaterial eingebettet sind, dessen Dotierung niedriger ist als die der Kanalgebiete (20) und insbesondere auch als die eines an einer von den Gate- und Kanalgebieten (19, 20) abgewandten Seite der zweiten Epitaxieschicht (13) vorgesehenen Kontaktgebiets (21).

4. Halbleiterstruktur nach Anspruch 1, **dadurch** g**ekennzeichnet,** dass die grabenförmigen Ausnehmungen (15) eine Tiefe (T) von mindestens 2 *µ*m, vorzugsweise von zwischen 2 *µ*m und 4 *µ*m, haben.

5. Halbleiterstruktur nach Anspruch 1, **dadurch gekennzeichnet, dass** die Kanalgebiete (20) eine mittlere seitliche Ausdehnung (B3) von zwischen 2 µm und 5 µm haben.

6. Halbleiterstruktur nach Anspruch 1, **dadurch gekennzeichnet, dass** die Seitenwände (16, 17) der grabenförmigen Ausnehmungen (15) einen gegenüber einer vertikalen Richtung (2) gemessenen Neigungswinkel (α) von zwischen 10° und 30° haben.

7. Herstellungsverfahren für eine Halbleiterstruktur (1) zur Steuerung eines vertikalen Stromflusses (32) zwischen einer ersten und einer zweiten Hauptelektrode (22, 23), die jeweils an einer von zwei einander gegenüberliegenden Hauptoberflächen eines Halbleiteraufbaus (5) aus Siliziumcarbid angeordnet sind, mittels einer an einer Steuerelektrode (7) anlegbaren Steuerspannung (U_{G}), wobei der Halbleiteraufbau (5) hergestellt wird, indem
a) eine erste Epitaxieschicht (12) auf ein Substrat (11) aufgebracht wird,
b) die erste Epitaxieschicht (12) mit einer Bearbeitungsöffnungen (28) aufweisenden Maskierschicht (29) belegt wird,
c) mehrere seitlich voneinander beabstandete grabenförmige Ausnehmungen (15) mit jeweils schrägen Seitenwänden (16, 17) und einem Boden (18) an von der Maskierschicht (29) nicht abgedeckten Bereichen in die erste Epitaxieschicht (12) geätzt werden,
d) ein Implantationsschritt zur gleichzeitigen Dotierung der schrägen Seitenwände (16, 17) und des Bodens (18) jeder der Ausnehmungen (15) durchgeführt wird, so dass dort Gate-Gebiete (19) mit einem zum übrigen Halbleiteraufbau (5) entgegen gesetzten Leitungstyp gebildet werden,
e) die Maskierschicht (29) entfernt wird,
f) eine zweite Epitaxieschicht (13) auf die mit den Ausnehmungen (15) versehene erste Epitaxieschicht (12) aufgebracht wird und
g) ein Kontaktgebiet (21) an einer von der ersten Epitaxieschicht (12) abgewandeten Seite der zweiten Epitaxieschicht (13) erzeugt wird.

8. Herstellungsverfahren nach Anspruch 7, **dadurch ge-kennzeichnet**, dass die Ausnehmungen (15) eine Längsrichtung (3) haben und die Längsrichtung (3) mit senkrechter Orientierung zu Wachstumsstufen (27), die sich in den Epitaxieschichten (12, 13) aufgrund einer Fehlorientierung des Substrats (11) bezüglich einer Kristallhauptachse (26) ergeben, vorgesehen wird.

9. Herstellungsverfahren nach Anspruch 7, **dadurch ge-kennzeichnet**, dass die beiden Epitaxieschichten (12, 13) mit im Wesentlichen gleicher Grunddotierung aufgebracht werden.

10. Herstellungsverfahren nach Anspruch 7, **dadurch gekennzeichnet, dass** auf dem Substrat (11) eine Zellenstruktur aus mehreren gleich ausgebildeten und nebeneinander angeordneten Zellen (5) jeweils in Form des Halbleiteraufbaus hergestellt wird, wobei die einzelnen Zellen (5) zur Bildung der Halbleiterstruktur elektrisch parallel geschaltet werden.
